# EUROPÄISCHE PATENTSCHRIFT

(11) **EP 2 607 310 B1**
(45) Veröffentlichungstag und Bekanntmachung des Hinweises auf die Patenterteilung: **17.09.2014**
(21) Anmeldenummer: 12196073.6
(22) Anmeldetag: 07.12.2012
(51) Int. Cl.: C01B 33/02, C01B 33/035, C01B 33/107, H01L 31/0368

(54) **Polykristallines Silicium**
Polycrystalline silicon
Silicium polycristallin

(30) Priorität: 21.12.2011 DE 102011089479
(43) Veröffentlichungstag der Anmeldung: 26.06.2013
(73) Patentinhaber: Wacker Chemie AG, 81737 München (DE)
(72) Erfinder: Baumann, Robert, Dr., 84489 Burghausen (DE); Hölzl, Robert, Dr., 84387 Julbach (DE); Weichselgartner, Michael, 84329 Wurmannsquick (DE)
(74) Vertreter: Killinger, Andreas

(56) Entgegenhaltungen:
- EP-A1- 2 431 329
- EP-B1- 0 345 618
- DE-A1-102011 077 455

## Beschreibung

Gegenstand der Erfindung ist polykristallines Silicium.

Im industriellen Maßstab wird Rohsilicium durch die Reduktion von Siliciumdioxid mit Kohlenstoff im Lichtbogenofen bei Temperaturen von etwa 2000 °C gewonnen.

Dabei erhält man sog. metallurgisches Silicium (Si_{mg}, "metallurgical grade") mit einer Reinheit von etwa 98-99 %.

Für Anwendungen in der Photovoltaik und in der Mikroelektronik muss das metallurgische Silicium gereinigt werden.

Dazu wird es beispielsweise mit gasförmigem Chlorwasserstoff bei 300-350 °C in einem Wirbelschichtreaktor zu einem Silicium enthaltenden Gas, beispielsweise Monosilan oder einem Halogensilan wie z.B. Trichlorsilan, umgesetzt. Darauf folgen Destillationsschritte, um das Silicium enthaltende Gas zu reinigen.

Dieses gereinigte Silicium enthaltende Gas dient dann als Ausgangsstoff für die Herstellung von hochreinem polykristallinem Silicium.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt, wobei ein Reaktionsgas enthaltend eine Silicium enthaltende Komponente und Wasserstoff eingeleitet wird.

Die Silicium enthaltende Komponente des Reaktionsgases ist in der Regel Monosilan oder ein Halogensilan der allgemeinen Zusammensetzung SiHₙX₄₋ₙ (n=0, 1, 2, 3; X = Cl, Br, I). Bevorzugt handelt es sich um ein Chlorsilan, besonders bevorzugt um Trichlorsilan. Überwiegend wird SiH₄ oder SiHCl₃ (Trichlorsilan, TCS) im Gemisch mit Wasserstoff eingesetzt.

Beim Siemens-Prozess stecken die Filamentstäbe üblicherweise senkrecht in am Reaktorboden befindlichen Elektroden, über die der Anschluss an die Stromversorgung erfolgt. Je zwei Filamentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich Polysilicium ab, wodurch der Stabdurchmesser mit der Zeit anwächst (CVD = Chemical Vapour Deposition / Gasphasenabscheidung).

Nach Beendigung der Abscheidung werden diese Polysiliciumstäbe üblicherweise mittels mechanischer Bearbeitung zu Bruchstücken unterschiedlicher Größenklassen weiterverarbeitet, gegebenenfalls einer nasschemischen Reinigung unterzogen und schließlich verpackt.

Das Polysilicium kann aber auch in Form von Stäben oder Stabstücken weiterverarbeitet werden. Dies gilt insbesondere für die Verwendung des Polysiliciums bei einem FZ-Verfahren, bei dem aus einem polykristallinen Stab ein Einkristall erzeugt wird.

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren).

Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Da die Qualitätsanforderungen an Polysilicium immer höher werden, sind Qualitätskontrollen während der gesamten Prozesskette unabdingbar. Untersucht wird das Material beispielsweise hinsichtlich Kontaminationen mit Metallen oder Dotierstoffen. Zu unterscheiden ist die Kontamination im Bulk und die Kontamination an der Oberfläche der Polysiliciumbruchstücke oder -stabstücke.

Es ist auch üblich, das erzeugte Polysilicium zum Zwecke der Qualitätskontrolle in einkristallines Material zu überführen. In diesem Fall wird das einkristalline Material untersucht. Auch hier spielen Metallkontaminationen, die bei den Kundenprozessen in der Halbleiterindustrie besonders kritisch einzuschätzen sind, eine besondere Rolle. Untersucht wird das Silicium aber auch hinsichtlich Kohlenstoff sowie Dotierstoffen wie Aluminium, Bor, Phosphor und Arsen.

DE 10 2011 077455 A1 offenbart ein Verfahren zur Bestimmung von Verunreinigungen in Silicium, umfassend die Schritte Abscheiden von polykristallinem Silicium auf wenigstens einem mittels einer Elektrode mit Strom versorgten und durch direkten Stromdurchgang erhitzen Filamentstab durch Einleiten von Reaktionsgas enthaltend eine Silicium enthaltende Komponente in einen CVD-Reaktor, wobei eine Bodenplatte des CVD-Reaktors, auf dem die wenigstens eine Elektrode zur Stromversorgung des wenigstens einen Filamentstabs angeordnet ist, mit einer Abdeckung aus Silicium abgedeckt ist; Erzeugung eines Stabs aus einkristallinem Silicium aus dem abgeschiedenen polykristallinen Siliciumstab mittels Zonenziehen; Untersuchung des einkristallinen Siliciumstabs auf Verunreinigungen mittels Photolumineszenzmessungen.

Dotierstoffe werden nach SEMI MF 1398 an einem aus dem polykristallinen Material erzeugten FZ-Einkristall (SEMI MF 1723) mittels Photolumineszenz analysiert. Alternativ kommt Niedrigtemperatur-FTIR (Fourier-Transform IR-Spektroskopie) zum Einsatz (SEMI MF 1630).

FTIR (SEMI MF 1188, SEMI MF 1391) ermöglicht die Bestimmung von Kohlenstoff- und Sauerstoffkonzentrationen.

Grundlagen des FZ-Verfahrens sind beispielsweise in der DE-3007377 A beschrieben.

Beim FZ-Verfahren wird ein polykristalliner Vorratsstab mit Hilfe einer Hochfrequenzspule nach und nach aufgeschmolzen und das schmelzflüssige Material durch Animpfen mit einem einkristallinen Impflingskristall und anschließendem Rekristallisieren in einen Einkristall überführt. Bei der Rekristallisation wird der Durchmesser des entstehenden Einkristalls zunächst kegelförmig vergrößert (Konusbildung) bis ein gewünschter Enddurchmesser erreicht ist (Stabbildung). In der Phase der Konusbildung wird der Einkristall auch mechanisch gestützt, um den dünnen Impflingskristall zu entlasten.

Darüber hinaus wird das zu analytischen Zwecken zum Einkristall gezogene Silicium hinsichtlich seiner Ladungsträgerlebensdauer untersucht. Zum Einsatz kommen hierbei unterschiedliche Messtechniken, z.B. nach SEMI PV9.

Die Ladungsträgerlebensdauer spielt bei der Anwendung des polykristallinen Siliciums im Halbleiter- wie auch im Photovoltaikbereich eine entscheidende Rolle, um einen möglichst hohen Wirkungsgrad der Bauteile zu gewährleisten.

DE 10 2005 044 328 A1 offenbart ein polykristallines Siliciummaterial mit einer Lebensdauer von 2 bis 500 µs. Zur Herstellung des polykristallinen Siliciummaterials kommt der Siemens-Prozess zum Einsatz, wobei als Silangas ein Trichlorsilan oder ein Monosilan mit mindestens 10 und höchstens 1000 ppb Bor verwendet wird. Das polykristalline Siliciummaterial wird für die Solarenergiegewinnung verwendet.

DE 10 2005 044 328 A1 zufolge liegt die Reinheit von Silan von Halbleitergüte bei weniger als 10 ppb Bor. Zudem beträgt die Summe von Fe, Cu, Ni, Cr, Zn und Na 5 ppb oder weniger (ICP-Methode), die Donormenge an A1 und B 0,1 ppb oder weniger (Photolumineszenz) und die Lebensdauer 1000 µs oder mehr (ASTM F28-91).

EP 0 345 618 B1 offenbart einen polykristallinen Siliciumstab mit weniger als 15 ppta Bor und weniger als 20 ppta Phosphor. Aus einem derartigen Stab kann mittels Schwebezonenverfahren einkristallines Silicium mit einem spezifischen Widerstand von mindestens 10.000 Ohmcm und einer Lebensdauer von mindestens 10.000 µs erzeugt werden.
Die Herstellung des polykristallinen Siliciumstabs erfolgt mittels des Siemens-Prozesses. Der polykristalline Siliciumstab enthält weniger als 5 ppta Aluminium und weniger als 0,1 ppma Kohlenstoff. Der Filamentstab enthält weniger als 0,2 ppba Bor und weniger als 0,2 ppba Phosphor.
Beim Siemens-Prozess in EP 0 345 618 B1 wird vorzugsweise Monosilan verwendet. Dies wird damit begründet, dass Bor und Phosphor von Monosilan leicht abgetrennt werden können. Dagegen erlaubt Trichlorsilan keine effektive Destillation, weil die dabei verwendeten Adsorber das Trichlorsilan mit Aluminium kontaminieren.

Aus dieser Problematik ergab sich die Aufgabenstellung der Erfindung.

Die Aufgabe der Erfindung wird gelöst durch polykristallines Silicium, das aus Trichlorsilan auf einem Filamentstab aus Silicium abgeschieden ist, mit Konzentrationen an Dotierstoffen von
1-10 ppta Bor,
1-20 ppta Phosphor,
1-10 ppta Arsen,
0,01-1 ppta Aluminium
sowie mit einer
Ladungsträgerlebensdauer von mindestens 2000 und höchstens 4500 µs.

Das erfindungsgemäße polykristalline Silicium weist eine äußerst niedrige Dotierstoffkonzentration, insbesondere eine niedrige Konzentration von Aluminium, und gleichzeitig eine relativ hohe Ladungsträgerlebensdauer auf.

Vorzugsweise beträgt die Konzentration an Phosphor 1-10 ppta.

Vorzugsweise beträgt die Konzentration an Bor 1-5 ppta.

Vorzugsweise beträgt die Konzentration an Arsen 1-5 ppta.

Die Dotierstoffkonzentrationen werden wie folgt bestimmt:
Wachstum eines Einkristalls mittels FZ aus einer Kernprobe des polykristallinen Siliciums, Abtrennen eines Stabstücks, Ätzen mit HF/HN03, Photolumineszenz.

Das polykristalline Silicium zeichnet sich weiterhin aus durch folgende Konzentrationen an Metallen im Innern (Bulk):
Fe 10-100 pptw, vorzugsweise 10-60 pptw, ganz besonders bevorzugt 10-40 pptw
Cu 10-250 pptw, vorzugsweise 10-100 pptw, ganz besonders bevorzugt 10-50 pptw
Ni 1-20 pptw, vorzugsweise 1-10 pptw
Cr 0,1-10 pptw, vorzugsweise 0,1-2 pptw
Zn 1-20 pptw, vorzugsweise 1-4 pptw
Na 10-1000 pptw, vorzugsweise 10-700 pptw, ganz besonders bevorzugt 10-400 pptw

Die Konzentration an Fe, Cu, Ni, Cr, Zn und Na beträgt in Summe weniger als 1400 pptw, vorzugsweise 35-850 pptw, ganz besonders bevorzugt 35-550 pptw.

Die Metallkonzentrationen werden bestimmt mittels INAA an einer Probe (geätzt mit HF/HN03), vgl. SEMI PV10-1110.

INAA (Instrumentelle Neutronenaktivierungsanalyse) beruht auf Reaktionen im Atomkern. Die Atome der zu untersuchenden Probe werden durch Neutronenstrahlung aktiviert. Während der Bestrahlung im Reaktor werden von einem Teil der Atomkerne Neutronen eingefangen - hierdurch werden instabile Isotope gebildet. Die Messung der bei ihrem radioaktiven Zerfall freiwerdenden Strahlung erlaubt Rückschlüsse auf Art und Menge der in der Analysenprobe vorhandenen Elemente.

Die Ladungsträgerlebensdauer wird bestimmt gemäß SEMI PV9-0611 ("Test Method for Excess Charge Carrier Decay in PV Silicon Materials by Non-Contact Measurements of Microwave Reflectance After a Short Illumination Pulse").

### Herstellung des polykristallinen Siliciums

### a) Herstellung von Trichlorsilan / Destillation

Das polykristalline Silicium wird erzeugt aus Umsetzung von Trichlorsilan und Wasserstoff in einem Siemensreaktor. TCS wird hauptsächlich über drei verschiedene Verfahren erzeugt.
**A)** Si + 3 HCl → SiHCl₃ + H₂ + Nebenprodukte
**B)** Si + 3 SiCl₄ + 2 H₂ → 4 SiHCl₃ + Nebenprodukte
**C)** SiCl₄ + H₂ → SiHCl₃ + HCl + Nebenprodukte

Bei diesen Prozessen entstehen neben anderen Nebenprodukten oder Verunreinigungen größere Mengen an Dichlorsilan (DCS).

So ist bekannt, dass bei der Hydrochlorierung von metallurgischem Silicium gemäß **(A)** etwa 0,1-1,0 % DCS im Reaktionsprodukt enthalten sind.

Die Umsetzung von metallurgischem Silicum mit Siliciumtetrachlorid (STC) und Wasserstoff gemäß **(B)** liefert in der Regel noch höhere DCS-Gehalte im Reaktionsprodukt, insbesondere wenn Kupfer als Katalysator für diesen Prozess verwendet wird.

Auch in der Hydrierung von STC gemäß **(C)** findet man im Reaktionsprodukt 0,05-1,0 % DCS.

Somit sind die Reaktionsprodukte Chlorsilanmischungen enthaltend TCS, DCS und STC.

Diese Chlorsilanmischungen werden durch ein destillatives Verfahren in mehreren Destillationskolonnen gereinigt. Es ist bekannt, dass die Mischungen borhaltig sind.

Bei der Destillation werden niedrig-siedende Borverbindungen mittels Kopfströmen enthaltend borangereichertes DCS und höhersiedende Borverbindungen mittels eines borangereicherten Sumpfstromes enthaltend Hochsieder aus den Destillationskolonnen abgezweigt.

Vorzugsweise wird die bereit gestellte Mischung aus Chlorsilanen mittels Reaktion von metallurgischem Silicium mit HCl in einem Wirbelschichtreaktor bei 350-400 °C erzeugt.

Vorzugsweise wird Chlorsilanmischung einer ersten Trennkolonne zugeführt, wobei in einer ersten Fraktion aus dieser Trennkolonne weniger als 10 ppm STC und in einer zweiten Fraktion aus dieser Trennkolonne weniger als 10 ppm TCS enthalten sind.

Vorzugsweise wird die zweite Fraktion aus der Trennkolonne einer zweiten Kolonne zugeführt und destillativ in einen Kopfstrom enthaltend STC und einen borangereicherten Sumpfstrom enthaltend Hochsieder getrennt.

Die erste Fraktion aus der Trennkolonne wird vorzugsweise einer dritten Kolonne zugeführt und destillativ in einen Sumpfstrom, der TCS enthält, und einen borangereicherten Kopfstrom, der neben TCS Niedersieder wie DCS enthält, getrennt.

Der Kopfstrom enthaltend TCS und Niedersieder wie DCS aus der dritten Kolonne wird vorzugsweise in eine vierte Kolonne geführt, wobei Inertgas eingespeist wird, wobei ein Kopfstrom aus der vierten Kolonne enthaltend borangereichertes DCS ausgeschleust wird, ein Sumpfstrom aus der vierten Kolonne der Trennkolonne wieder zugeführt wird und ein Nebenstrom enthaltend Abgas aus der vierten Kolonne entsorgt wird.

Jene vierte Kolonne wird vorzugsweise in Überdruck betrieben.

Vorzugsweise wird der Kopfstrom aus der dritten Kolonne enthaltend TCS und Niedersieder wie DCS vor Zuführen in die vierte Kolonne verflüssigt.

Die wesentlichen Schritte sind die Erzeugung von Chlorsilanen, bevorzugt TCS, durch Hydrochlorierung von metallurgischem Silicium, die destillative Aufreinigung der Chlorsilane und die Abtrennung von stark mit Bor verunreinigten DCS- und STC-Fraktionen aus dieser Mischung aus Chlorsilanen.

Damit werden die höher siedenden Bor-Verunreinigungen in einen STC-Teilstrom und niedrig siedenden Bor-Verbindungen in einem DCS-Teilstrom aufkonzentriert.

Das so gereinigte Trichlorsilan weist einen äußerst niedrigen Borgehalt auf.

Bevor das gereinigte Trichlorsilan zur Verwendung einem Reaktor zur Abscheidung des polykristallinen Siliciums freigegeben wird, erfolgt eine Messung des Dotierstoffgehalts im Trichlorsilan.

Das für die Abscheidung verwendete TCS muss folgenden Bedingungen genügen:
Das TCS weist höchstens 20 ppta Bor, höchstens 90 ppta Phosphor, weniger als 20 ppta Arsen und weniger als 1 ppta Aluminium auf.
Vorzugsweise enthält das TCS 1-20 ppta Bor.
Vorzugsweise enthält das TCS 1-90 ppta Phosphor.
Vorzugsweise enthält das TCS 1-20 ppta Arsen.
Vorzugsweise enthält das TCS 0,01 bis 1 ppta Aluminium.

Die Bestimmung der Dotierstoffkonzentration in TCS erfolgt indirekt mittels Testabscheidung in einem kleinen Siemens-Testreaktor, wobei als Silicium-Komponente jenes TCS verwendet wird. Das dabei abgeschiedene Polysilicium wird durch Wachstum eines Einkristalls mittels FZ aus dem polykristallinen Silicium und Abtrennen eines Stabstücks weiterverarbeitet. Nach einem Ätzschritt mit HF/HN03 erfolgt Messung der Dotierstoffkonzentration mittels Photolumineszenz. Um sicherzustellen, dass das TCS den o. g. Bedingungen genügt, kann das durch ein destillatives Verfahren gereinigte TCS während der Analyse mittels Testabscheidung in einen Tank gefüllt werden, wobei der Tank erst nach Vorliegen des Messergebnisses für die Abscheidung von polykristallinem Silicium freigegeben wird.

Durch die 100% Überwachung des Trichlorsilan kann eine gleich bleibende Qualität des hergestellten polykristallinen Siliciums sichergestellt werden.

### b) Testabscheidung zur Überwachung der Dotierstoffe im Trichlorsilan

Bei der Testabscheidung wird polykristallines Silicium unter Verwendung des zu untersuchenden TCS abgeschiednen.

Dazu wird ein Reaktor verwendet, der Filamentstäbe umfasst, die mittels einer Elektrode mit Strom versorgt und durch direkten Stromdurchgang erhitzt werden. Durch Ein leiten von TCS und Wasserstoff scheidet sich an den Filamentstäben polykristallines Silicium ab.

Wichtig ist es, sicherzustellen, dass das Polysilicium bei der Abscheidung nicht kontaminiert wird. Nur so lässt die Testabscheidung einen exakten Rückschluss auf die Reinheit des verwendeten TCS zu.

Zu diesem Zweck ist ein Boden des Reaktors, auf dem die Elektroden zur Stromversorgung der Filamentstäbe angeordnet sind, mit Silicium abgedeckt.

Vorzugsweise handelt es sich dabei um Silicium mit definiertem und möglichst niedrigem Dotierstoffgehalt.

Vorzugsweise handelt es sich um Silicium mit folgenden Dotierstoffkonzentrationen:
Bor max. 10 ppta und Phosphor max. 20 ppta.

Vorzugsweise enthält das Silicium darüber hinaus max. 20 ppta Aluminium und max. 20 ppta Arsen.

Nach der Abscheidung wird der polykristalline Siliciumstab aus dem Reaktor entnommen. Von einer Kernprobe des Polysiliciumstabs wird mittels Zonenziehen ein Einkristall erzeugt. Dieser Einkristall bzw. ein von diesem abgetrenntes Stabstück, wird anschließend auf Verunreinigungen, insbesondere aus Verunreinigungen mit Dotierstoffen, untersucht. Nach einem Ätzschritt mit HF/HN03 erfolgt Messung der Dotierstoffkonzentration mittels Photolumineszenz.

Die Nachweisgrenzen für Dotierstoffe liegen bei etwa 1 ppta.

### c) Abscheidung des polykristallinen Silicium

Falls die Bestimmung der Dotierstoffkonzentrationen im TCS nach der Testabscheidung ergibt, dass das TCS den o. g. Bedingungen hinsichtlich Bor-, Phosphor-, Arsen- und Aluminiumgehalt genügt, kann es zur Abscheidung des erfindungsgemäßen polykristallinen Siliciums verwendet werden.

Die Abscheidung erfolgt in einem herkömmlichen Siemensprozess.

Der Siemensreaktor umfasst Zufuhrleitungen zum Zuführen von Reaktionsgasen (TCS und Wasserstoff) in den Reaktor sowie Abführleitungen zum Abführen von bei der Abscheidung entstehendem Abgas.

Nach Beendigung der Abscheidung, die darin besteht, dass die Siliciumstäbe auf Raumtemperatur abgekühlt werden, werden der Reaktor geöffnet und die Siliciumstäbe aus dem Reaktor entnommen.

Ab Öffnen des Reaktors und während des Ausbaus der Siliciumstäbe wird über die Zufuhr- und die Abführleitungen ein Inertgas in den Reaktor gespült. Als Inertgas können Stickstoff oder ein Edelgas wie Argon verwendet werden.

Die Inertgasspülung ist detailliert beschrieben in US 7,927,571, auf das hier in vollem Umfang Bezug genommen wird.

Neben den niedrigerem Phosphorpegel wird dadurch sichergestellt, dass keine Feuchte in den Prozess eingebracht werden kann. Dies verhindert Korrosion oder sonstige Einbringung von Metallen in das polykristalline Silicium.

### Beispiele

TCS wurde in einem Testreaktor verwendet, um es anschließend auf Bor- und Phosphorgehalt zu untersuchen.

Es wurden 9 TCS-Chargen untersucht, die eine zuvor beschriebene Destillation durchlaufen haben.

Dotierstoffe (B, P) wurden nach SEMI MF 1398 an einem aus dem polykristallinen Material erzeugten FZ-Einkristall (SEMI MF 1723) mittels Photolumineszenz analysiert.

**Tabelle 1** zeigt die sich dabei ergebenden Werte in ppta.

**Tabelle 1**

| | P | B |
|---|---|---|
| #1 | 19,4 | 3,7 |
| #2 | 19,1 | 3,0 |
| #3 | 19,4 | 3,3 |
| #4 | 21,1 | 3,7 |
| #5 | 19,2 | 3,9 |
| #6 | 19,2 | 3,4 |
| #7 | 19,3 | 3,5 |
| #8 | 19,1 | 3,0 |
| #9 | 19,8 | 2,8 |

Bis auf Probe #4 erfüllen alle TCS-Chargen Bedingung, dass der Borgehalt im TCS höchstens 20 ppta betragen darf.

Dies können zur Abscheidung des erfindungsgemäßen polykristallinen Siliciums verwendet werden.

An fünf mit solchem TCS erzeugten Chargen an polykristallinem Silicium wurden Dotierstoffe, Metalle und Lebensdauer bestimmt.

Metallgehalte wurden nach SEMI PV10-1110 an einer aus dem polykristallinen Material erzeugten Probe mittels INAA analysiert.

**Tabelle 2** zeigt die sich dabei ergebenden Werte in pptw.

**Tabelle 2**

| Element | #1 | #2 | #3 | #4 | #5 |
|---|---|---|---|---|---|
| Na | 729 | 936 | 934 | 899 | 855 |
| Fe | 74 | 58 | 98 | 98 | 44 |
| Cu | 247 | 149 | 131 | 41 | 41 |
| Ni | 15 | 8, 1 | 12,9 | 17 | 7,5 |
| Cr | 9,41 | 3, 1 | 1,6 | 1, 6 | 0,89 |
| Zn | 17,15 | 3,8 | 7,6 | 5,7 | 3,4 |

Zudem wurden die Dotierstoffe des polykristallinen Siliciums bestimmt.

**Tabelle 3** zeigt die sich ergebenden Werte in ppta.

**Tabelle 3**

| Element | #1 | #2 | #3 | #4 | #5 |
|---|---|---|---|---|---|
| P | 13 | 14 | 15 | 16 | 19 |
| B | 6 | 5 | 5 | 6 | 6 |
| As | 3 | 6 | 6 | 4 | 6 |
| Al | 0,02 | 0,05 | 0,1 | 0,2 | 0,08 |

Zur Messung der Lebensdauer wurden aus dem polykristallinen Silicium stabförmige Proben mit einem Durchmesser von 19 mm gebohrt und nach ASTM Std. F1723-96 zu einem monokristallinen Stab nach dem FZ-Verfahren gezogen. Der resultierende Einkristall hatte eine Stabdicke von 19 mm.

Die Ladungsträgerlebensdauer wurde am Einkristall gemessen.

Es wurde ein berührungsloses Verfahren nach SEMI PV9-0611 angewendet, bei dem induktiv die Veränderung der Leitfähigkeit mit der Zeit nach einer Lichtanregung bestimmt wird.

**Tabelle 4** zeigt die sich dabei ergebenden Werte in µs.

**Tabelle 4**

| Messung | 1 | 2 | 3 | 4 | 5 | 6 | 7 | 8 | 9 | 10 |
|---|---|---|---|---|---|---|---|---|---|---|
| Lebensdauer | 2568 | 2601 | 2577 | 2653 | 2808 | 3593 | 4056 | 2581 | 2683 | 2946 |

## Patentansprüche

1. Polylcristallines Silicium, das aus Trichlorsilan auf einem Filamentstab aus Silicium abgeschieden ist, mit Konzentrationen an Dotierstoffen von
1-10 ppta Bor,
1-20 ppta Phosphor,
1-10 ppta Arsen,
und 0,01-1 ppta Aluminium,
sowie mit einer Ladungsträgerlebensdauer von mindestens 2000 und höchstens 4500 µs.

2. Polykristallines Silicium nach Anspruch 1, mit einer Konzentration an Phosphor von 1-10 ppta.

3. Polykristallines Silicium nach Anspruch 1 oder nach Anspruch 2, mit einer Konzentration an Bor von 1-5 ppta.

4. Polykristallines Silicium nach einem der Ansprüche 1 bis 3, mit einer Konzentration an Arsen von 1-5 ppta.

5. Polykristallines Silicium nach einem der Ansprüche 1 bis 4, mit einer Bulk-Konzentration von Fe, Cu, Ni, Cr, Zn und Na in Summe von weniger als 1400 pptw, vorzugsweise 35-850 pptw, besonders bevorzugt 35-550 pptw.

6. Polykristallines Silicium nach einem der Ansprüche 1 bis 5, mit einer Bulk-Konzentration von Fe von 10-100 pptw.

7. Polykristallines Silicium nach einem der Ansprüche 1 bis 6, mit einer Bulk-Konzentration von Cu von 10-250 pptw.

8. Polykristallines Silicium nach einem der Ansprüche 1 bis 7, mit einer Bulk-Konzentration von Ni von 1-20 pptw.

9. Polykristallines Silicium nach einem der Ansprüche 1 bis 8, mit einer Bulk Konzentration von Cr von 0,1-10 pptw.

10. Polykristallines Silicium nach einem der Ansprüche 1 bis 9, mit einer Bulk-Konzentration von Zn von 1-20 pptw.

11. Polykristallines Silicium nach einem der Ansprüche 1 bis 10, mit einer Bulk-Konzentration von Na von 10-1000 pptw.

## Claims

1. Polycrystalline silicon deposited from trichlorosilane on a filament rod of silicon, having concentrations of dopants of
1-10 ppta of boron,
1-20 ppta of phosphorus,
1-10 ppta of arsenic,
and 0.01-1 ppta of aluminum,
and having a charge carrier lifetime of at least 2000 and at most 4500 µs.

2. Polycrystalline silicon according to Claim 1, having a phosphorus concentration of 1-10 ppta.

3. Polycrystalline silicon according to Claim 1 or according to Claim 2, having a boron concentration of 1-5 ppta.

4. Polycrystalline silicon according to any of Claims 1 to 3, having an arsenic concentration of 1-5 ppta.

5. Polycrystalline silicon according to any of Claims 1 to 4, having a bulk concentration of Fe, Cu, Ni, Cr, Zn and Na totaling less than 1400 pptw, preferably 35-850 pptw, more preferably 35-550 pptw.

6. Polycrystalline silicon according to any of Claims 1 to 5, having a bulk concentration of Fe of 10-100 pptw.

7. Polycrystalline silicon according to any of Claims 1 to 6, having a bulk concentration of Cu of 10-250 pptw.

8. Polycrystalline silicon according to any of Claims 1 to 7, having a bulk concentration of Ni of 1-20 pptw.

9. Polycrystalline silicon according to any of Claims 1 to 8, having a bulk concentration of Cr of 0.1-10 pptw.

10. Polycrystalline silicon according to any of Claims 1 to 9, having a bulk concentration of Zn of 1-20 pptw.

11. Polycrystalline silicon according to any of Claims 1 to 10, having a bulk concentration of Na of 10-1000 pptw.

## Revendications

1. Silicium polycristallin, qui est déposé à partir de trichlorosilane sur une barre filamentaire de silicium, avec des concentrations de matières de dopage de
1-10 ppta de bore,
1-20 ppta de phosphore,
1-10 ppta d'arsenic,
et 0,01-1 ppta d'aluminium,
ainsi qu'avec une durée de vie des porteurs de charge d'au moins 2 000 et d'au maximum 4 500 µs.

2. Silicium polycristallin selon la revendication 1, ayant une teneur en phosphore de 1-10 ppta.

3. Silicium polycristallin selon la revendication 1 ou la revendication 2, ayant une teneur en bore de 1-5 ppta.

4. Silicium polycristallin selon l'une quelconque des revendications 1 à 3, ayant une teneur en arsenic de 1-5 ppta.

5. Silicium polycristallin selon l'une quelconque des revendications 1 à 4, ayant une teneur en masse en Fe, Cu, Ni, Cr, Zn et Na au total de moins de 1 400 ppt en poids, de préférence de 35-850 ppt en poids, de façon particulièrement préférée de 35-550 ppt en poids.

6. Silicium polycristallin selon l'une quelconque des revendications 1 à 5, ayant une teneur en masse en Fe de 10-100 ppt en poids.

7. Silicium polycristallin selon l'une quelconque des revendications 1 à 6, ayant une teneur en masse en Cu de 10-250 ppt en poids.

8. Silicium polycristallin selon l'une quelconque des revendications 1 à 7, ayant une teneur en masse en Ni de 1-20 ppt en poids.

9. Silicium polycristallin selon l'une quelconque des revendications 1 à 8, ayant une teneur en masse en Cr de 0,1-10 ppt en poids.

10. Silicium polycristallin selon l'une quelconque des revendications 1 à 9, ayant une teneur en masse en Zn de 1-20 ppt en poids.

11. Silicium polycristallin selon l'une quelconque des revendications 1 à 10, ayant une teneur en masse en Na de 10-1000 ppt en poids.
